(19) Europäisches Patentamt

European Patent Office

Office européen des brevets

(11) EP 0 668 619 B1

(12) EUROPEAN PATENT SPECIFICATION

(45) Date of publication and mention
of the grant of the patent:
**08.09.1999 Bulletin 1999/36**

(51) Int Cl.⁶: **H01L 35/22**

(21) Application number: **95300984.2**

(22) Date of filing: **16.02.1995**

(54) **Thermoelectric semiconductor material**

Thermoelektrisches Halbleitermaterial

Matériau semi-conducteur thermoélectrique

(84) Designated Contracting States:
**DE**

(30) Priority: **22.02.1994 JP 2438794**
**29.12.1994 JP 33889394**

(43) Date of publication of application:
**23.08.1995 Bulletin 1995/34**

(73) Proprietor: **KABUSHIKI KAISHA OHARA**
**Sagamihara-shi, Kanagawa (JP)**

(72) Inventors:
• **Ochi, Yasuo, c/o K.K. Ohara**
**Sagamihara-shi, Kanagawa (JP)**
• **Ohara, Kazuo, c/o K.K. Ohara**
**Sagamihara-shi, Kanagawa (JP)**

(74) Representative: **Perry, Robert Edward**
**GILL JENNINGS & EVERY**
**Broadgate House**
**7 Eldon Street**
**London EC2M 7LH (GB)**

(56) References cited:
US-A- 4 938 244      US-A- 4 969 956
US-A- 5 275 001

• THIN SOLID FILMS, vol.176, no.1, September
1989, LAUSANNE,CH pages 73 - 78, XP87274
M.YUST ET AL. 'transparant thin film
thermocouple'

**Description**

BACKGROUND OF THE INVENTION

Field of the Invention

The present invention relates to a thermoelectric semiconductor material, in particular, to a thermoelectric material which is adapted to be used for a Peltier cooling element, an electric generating element, or the like, and which exhibits the Peltier effect in which a temperature difference is generated by using an electric energy or exhibits the Seebeck effect in which an electric energy is generated by using a temperature difference.

Description of Related Art

Thermoelectric performance of such a thermoelectric material which exhibits the Peltier effect or the Seebeck effect is evaluated by the figure of merit Z (dimension: $K^{-1}$) which is estimated by the following equation. The larger the value of the figure of merit Z becomes, the better the thermoelectric performance is.

$$Z = \alpha^2 \sigma / \kappa$$

where, $\alpha$ is a Seebeck coefficient ($\mu V/K$), $\sigma$ is an electrical conductivity ($(m\Omega)^{-1}$), and $\kappa$ is a thermal conductivity (W/mK). Therefore, in order to obtain a thermoelectric material having a high thermoelectric performance, it is necessary to select a material having a large Seebeck coefficient $\alpha$, a large electrical conductivity $\sigma$, and a small thermal conductivity $\kappa$.

Generally, a metal material or a semiconductor material is known as a thermoelectric material. Because Wiedemann Franz's law which says that the ratio of the electrical conductivity a to the thermal conductivity $\kappa$ at a temperature does not depend upon the kind of metal and therefore has a constant value in any kind of metal, holds in a metal material, there is little chance of obtaining a thermoelectric material having a high thermoelectric performance by selecting a specific kind of metal.

On the contrary, in semiconductor materials, the above described law does not necessarily hold, and it is possible to select a specific material having a large electrical conductivity $\sigma$ and a small thermal conductivity $\kappa$. Because the value of the Seebeck coefficient $\alpha$ of a semiconductor material is usually about ten to several hundreds times that of a metal material, there is a good chance of obtaining a thermoelectric material having a high thermoelectric performance. Therefore, various kinds of semiconductor materials have been developed as thermoelectric materials.

Transition silicide which is used for thermoelectric power generation at a high temperature, and chalcogenide which is used as a material for Peltier cooling, are representative thermoelectric semiconductor materials which were conventionally developed. In these materials, a chalcogenide material of the $Bi_2Te_3$ system, e.g. $Bi_2Te_3$, $Sb_2Te_3$, TbTe or GeTe, used as a thermoelectric cooling device, usually presents the best thermoelectric performance near room temperature and has a high Z value, of more than $10^{-3}K^{-1}$. However, the thermoelectric performance is much reduced, at temperatures other than room temperature. In particular, because the Z value is about $10^{-5}K^{-1}$ at more than about 250°C, and oxidation and decomposition occur at high temperature, this chalcogenide material cannot be used over a wide temperature range.

In general, semiconductor materials other than the chalcogenide material of the $Bi_2Te_3$ system can only be used as a thermoelectric material in a very narrow temperature range.

Summary of the Invention

According to the present invention, a thermoelectric semiconductor material comprises a double oxide and a trace additive, wherein the double oxide has a normal spinel crystal structure represented by $CdIn_2O_4$ or an inverse spinel crystal structure represented by $MgIn_2O_4$ and wherein the trace additive is 0.01-5.0 atomic % of the thermoelectric semiconductor material, the additive consisting of at least one element selected from those in Group Ia, IIa, IVa, Ib, IIIb or IVb, in the second to the sixth period of the Periodic Table 3d-transition elements and rare earth elements.

The novel material can exhibit a good Z value over a wide temperature range, e.g., in the range of 100K (about -173°C) to 1000K (about 727°C) , and which does not fluctuate widely.

The present invention is based on the consideration that, not only the electrical conductivity of a solid which defines the performance of a Peltier element, but also the Seebeck coefficient, are determined by the atom which is a crystal structure unit of the solid material and by the structure thereof, i.e., the bond distance between cations, the coordinating angle, and the overlap of electron orbits which is defined by the three-dimensional arrangement of oxygen ligands and the like.

A spinel structure, which is considered to be a rutile chain which is a normal chain sharing an edge of an octahedron parallel to [110] having connected tetrahedral coordinating cations, and in which free electrons may be transmitted in the conduction band which is formed by the s-orbit of the central ion in an oxygen octahedron, may thus be effective as a host oxide crystal.

Further, the concentration of free electrons or holes may be controlled by adding the trace impurity into the host oxide crystal. Accordingly, the electrical conductivity and the Seebeck coefficient of the material can be controlled.

Description of the Invention

The trace additive may be, for example, an element of Group Ia, IIa, IVa, Ib, IIIb or IVb, in the second to the sixth period of the Periodic Table, e.g., zinc (Zn), gallium (Ga), germanium (Ge), tin (Sn) or lead (Pb), a 3d-transition element, e.g., iron (Fe), cobalt (Co) or nickel (Ni), or a rare earth element, e.g., scandium (Sc), yttrium (Y) or a lanthanoid having an atomic number of 57-71. The additive may comprise an element of the first type and at least one 3d-transition or rare earth element.

It has been found that, when the concentration of the trace additive is more than the upper limit or less than the lower limit, the specific resistance of the material increases, so that it is difficult to make a semiconductor material in air. For good electrical conductivity, it is preferred that the concentration of the trace additive is not more than 1.0 atomic %, more preferably not more than 0.5 atomic %.

The double oxide can be prepared by a conventional sintering method. The method does not require a specific atmosphere and the temperature required for sintering the double oxide is relatively low, i.e., approximately 1000°C-1500°C, in comparison with that required for other ceramics.

Alternatively, conventional physical or chemical vapour deposition, e.g. sputtering, or a CVD method, liquid deposition including a sol-gel method, or a melting method, can be adopted. The material may be obtained as a lump or a thin film, depending on the method of growth.

The following Embodiments serve to illustrate the invention.

[Embodiment 1]

Equimolar amounts of MgO or cdo and $In_2O_3$ were mixed in a mortar. Each mixture was put in a cylindrical forming die having a diameter of 20 mm, and a uniaxial pressure of 600 kg/cm$^2$ was applied. The mixture was held at 1200°C, in the case of Mg and 850°C in the case of Cd, under atmospheric pressure, for 5 hours, and thereafter cooled naturally and calcined. Each sintered body which had been calcined was ground and was put into the forming die. This was pressed under a pressure of 800 kg/cm$^2$, and was further compression-moulded under a pressure of 3 ton/cm$^2$ by isostatic pressing. The moulded body was held at 1500°C in the case of Mg and 1020°C in the case of Cd, under atmospheric pressure, for 10 hours, cooled naturally, and then calcined.

The crystal structures, which can be presumed from the electric charge and the ionic radius of each sample according to Shannon's ionic radius data (R. D. Shannon et al, Acta Cryst. B25: 925-946 (1969)), and the values of the ionic radii in tetrahedral coordination and octahedral coordination, are shown in Table 1.

TABLE 1

| Sample No. | M (in $MIn_2O_4$) | Ionic Radius (nm (Å)) | | Structure |
|---|---|---|---|---|
| | | Tetrahedral coordination | Octahedral Coordination | |
| 1 | Mg | 0.057 (0.57) | 0.072 (0.72) | Inverse Spinel |
| 2 | cd | 0.058 (0.58) | 0.075 (0.75) | Normal Spinel |

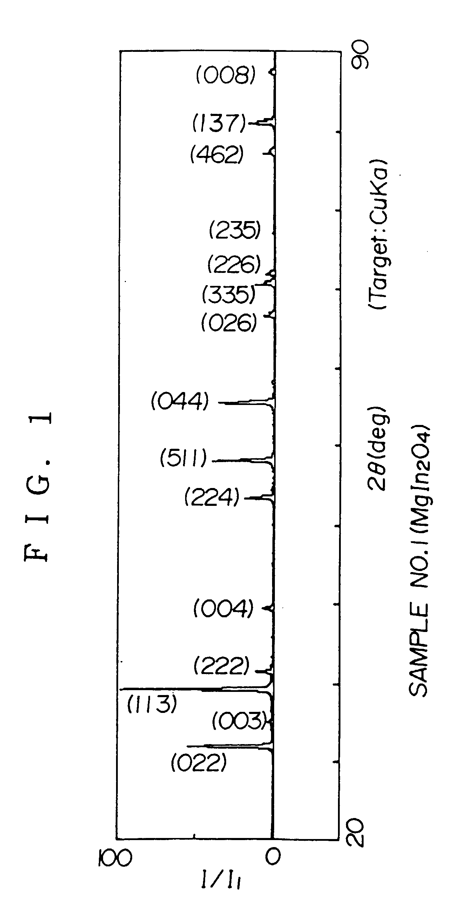

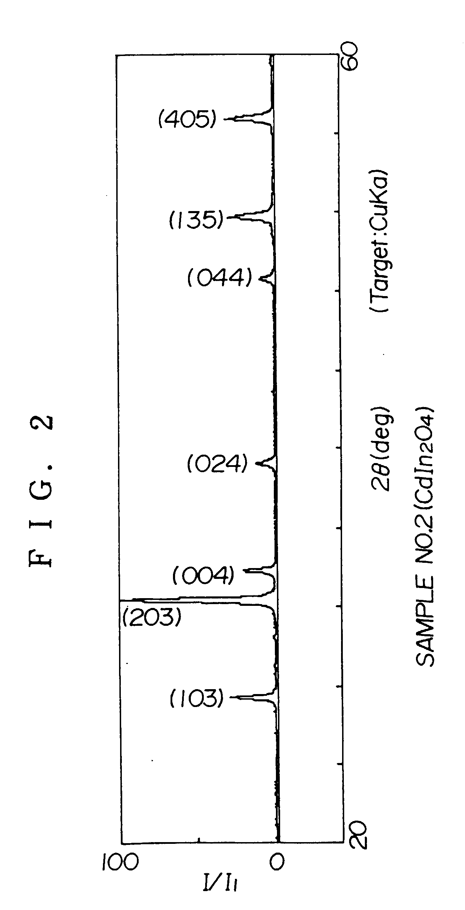

X-ray diffractions (XRD) were carried out for Samples Nos. 1 ($MgIn_2O_4$) and 2 ($CdIn_2O_4$). The respective diffraction patterns are shown in Figs. 1 and 2. Analysis indicated that each sample was of a cubic system. $MgIn_2O_4$ had an inverse spinel crystal structure having a crystal lattice constant of 0.8865 nm (8.865Å), and $CdIn_2O_4$ had a normal spinel crystal structure having a crystal lattice constant of 0.9160 nm (9.160Å).

For Samples Nos. 1 ($MgIn_2O_4$) and 2 ($CdIn_2O_4$), the Seebeck coefficient $\alpha$, the electrical conductivity $\sigma$, and the thermal conductivity $\kappa$ at room temperature were measured, and the respective values Z were calculated on the basis of these values; they are $1.76 \times 10^{-4}$ and $1.90 \times 10^{-4}$.

It was found that, for 13 other elements M, i.e. Ca, Sr, Ba, Eu, Cr, Mn, Fe, Co, Ni, Cu, Zn, Sn and Pb, it was impossible to obtain a crystal having a spinel structure and good electrical conductivity without, say, preparation under a sealed and depressurised atmosphere.

[Embodiment 2]

It is understood that by addition of Ga, Ge, or La, these samples have a high thermoelectric performance, that is, the figure of merit Z of several times to ten and several times that of a sample without such additive, which is more than $10^{-3}K^{-1}$ that is considered to be good, as shown in Table 2.

Next, for Sample No. 2-1 (Ga concentration: 1.0 atomic %), Sample No. 2-3 (Ge concentration: 1.0 atomic %), and Sample No. 2-5 (La concentration: 0.1 atomic %), the Seebeck coefficient $\alpha$, the electrical conductivity $\sigma$, and the thermal conductivity $\kappa$ at temperatures of 100K, 300K, 400K, 600K, 800K, 900K, and 1000K, were measured, and the respective figures of merit Z were calculated on the basis of these values, as shown in Tables 3, 4, and 5. It will be evident that the Z values are high, more than $10^{-3}K^{-1}$, and that they fluctuate within a narrow range.

TABLE 2

| SAMPLE NO. | SUBSTITUTIONAL ATOM | CONCENTRATION (ATOMIC %) | FIGURE OF MERIT Z(/K) |
|---|---|---|---|
| 2 | | 0. 0 | $1.90 \times 10^{-4}$ |
| 2-1 | Ga | 1. 0 | $3.2 \times 10^{-3}$ |
| 2-2 | | 5.0 | $1.5 \times 10^{-3}$ |
| 2-3 | Ge | 1.0 | $3.0 \times 10^{-3}$ |
| 2-4 | | 5.0 | $2.6 \times 10^{-3}$ |
| 2-5 | La | 0.1 | $2.4 \times 10^{-3}$ |

TABLE 3

| SAMPLE NO. | TEMPERATURE (K) | FIGURE OF MERIT Z(/K) |
|---|---|---|
| 2-1 | 100 | $3.3 \times 10^{-3}$ |
| | 300 | $3.2 \times 10^{-3}$ |
| | 400 | $2.8 \times 10^{-3}$ |
| | 600 | $2.8 \times 10^{-3}$ |
| | 800 | $2.9 \times 10^{-3}$ |
| | 900 | $3.0 \times 10^{-3}$ |
| | 1000 | $1.8 \times 10^{-3}$ |

TABLE 4

| SAMPLE NO. | TEMPERATURE (K) | FIGURE OF MERIT Z(/K) |
|---|---|---|
| 2-3 | 100 | $3.3 \times 10^{-3}$ |
| | 300 | $3.0 \times 10^{-3}$ |
| | 400 | $3.1 \times 10^{-3}$ |
| | 600 | $3.1 \times 10^{-3}$ |
| | 800 | $3.2 \times 10^{-3}$ |
| | 900 | $3.4 \times 10^{-3}$ |
| | 1000 | $2.2 \times 10^{-3}$ |

4

TABLE 5

| SAMPLE NO. | TEMPERATURE (K) | FIGURE OF MERIT Z(/K) |
|---|---|---|
| 2-5 | 100 | $3.5 \times 10^{-3}$ |
| | 300 | $2.4 \times 10^{-3}$ |
| | 400 | $2.5 \times 10^{-3}$ |
| | 600 | $2.6 \times 10^{-3}$ |
| | 800 | $3.0 \times 10^{-3}$ |
| | 900 | $3.4 \times 10^{-3}$ |
| | 1000 | $1.9 \times 10^{-3}$ |

## Claims

1. A thermoelectric semiconductor material which comprises a double oxide and a trace additive, wherein the double oxide has a normal spinel crystal structure represented by $CdIn_2O_4$ or an inverse spinel crystal structure represented by $MgIn_2O_4$ and wherein the trace additive is 0.01-5.0 atomic % of the thermoelectric semiconductor material, the additive consisting of at least one element selected from Groups Ia, IIa, IVa, Ib, IIIb and IVb, in the second to the sixth period of the Periodic Table, 3d-transition elements and rare earth elements.

2. A material as claimed in claim 1, wherein the trace additive is lead.

3. A material as claimed in claim 1, wherein the trace additive is Ga or Ge.

4. A material as claimed in claim 1, wherein the trace additive is La.

5. Use of a material as claimed in any preceding claim, in thermoelectric conversion.

## Patentansprüche

1. Thermoelektrisches Halbleiter-Material, das ein Doppeloxid und ein Spurenadditiv umfaßt, wobei das Doppeloxid eine normale Spinell-Kristallstruktur, die durch $CdIn_2O_4$ verkörpert wird, oder eine inverse Spinell-Kristallstruktur, die durch $MgIn_2O_4$ verkörpert wird, aufweist und wobei das Spurenadditiv 0,01 bis 5,0 Atom-% des thermoelektrischen Halbleitermaterials beträgt, wobei das Additiv aus mindestens einem Element besteht, welches aus den Gruppen Ia, IIa, IVa, Ib, IIIb und IVb in der zweiten bis sechsten Periode des Periodensystems, 3d-Übergangselementen und Seltenerdelementen ausgewählt ist.

2. Material nach Anspruch 1, in dem das Spurenadditiv Blei ist.

3. Material nach Anspruch 1, in dem das Spurenadditiv Ga oder Ge ist.

4. Material nach Anspruch 1, in dem das Spurenadditiv La ist.

5. Verwendung eines Materials nach irgendeinem vorangehenden Anspruch bei der thermoelektrischen Umwandlung.

## Revendications

1. Matériau semi-conducteur thermo-électrique, qui comprend un oxyde double et un additif à l'état de trace, dans lequel l'oxyde double présente une structure cristalline de spinelle normal représentée par $CdIn_2O_4$ ou une structure cristalline de spinelle inverse représentée par $MgIn_2O_4$, et dans lequel l'additif à l'état de trace fait 0,01 - 5,0% atomiques du matériau semi-conducteur thermoélectrique, l'additif consistant en au moins un élément choisi dans les groupes Ia, IIa, IVa, Ib, IIIb et IVb, de la seconde à la sixième période du Tableau Périodique, des éléments de transition 3d et des éléments des terres rares.

2. Matériau selon la revendication 1, dans lequel l'additif à l'état de trace est le plomb.

3. Matériau selon la revendication 1, dans lequel l'additif à l'état de trace est le Ga ou le Ge.

4. Matériau selon la revendication 1, dans lequel l'additif à l'état de trace est le La.

5. Utilisation d'un matériau selon l'une quelconque des revendications précédentes, pour une conversion thermoélectrique.

# F I G. 1

F I G. 2

(405)

(135)

(044)

(024)

(004)

(203)

(103)

100

I/I₁

0

20

2θ(deg)

60

(Target:CuKa)

SAMPLE NO.2(CdIn₂O₄)